**Europäisches Patentamt**

**European Patent Office**

**Office européen des brevets**

(19)

(11) Veröffentlichungsnummer : **0 046 963**
**B1**

# (12) EUROPÄISCHE PATENTSCHRIFT

(45) Veröffentlichungstag der Patentschrift :
20.02.85

(51) Int. Cl.⁴ : **G 06 F 11/10**

(21) Anmeldenummer : 81106564.8

(22) Anmeldetag : 24.08.81

(54) Schaltungsanordnung zur Erkennung und Korrektur von Fehlerbündeln.

(30) Priorität : 28.08.80 DE 3032468

(43) Veröffentlichungstag der Anmeldung :
10.03.82 Patentblatt 82/10

(45) Bekanntmachung des Hinweises auf die Patenterteilung : 20.02.85 Patentblatt 85/08

(84) Benannte Vertragsstaaten :
AT BE CH FR GB IT LI NL SE

(56) Entgegenhaltungen :
DE-A- 2 906 578
US-A- 3 801 955
IEEE TRANSACTIONS ON INFORMATION THEORY,
vol. IT-15, no. 1, Januar 1969, Selten 109-113 R.T.
CHEIN: "Burst-correcting codes with high-speed
decoding"

(73) Patentinhaber : **Siemens Aktiengesellschaft**
**Berlin und München Wittelsbacherplatz 2**
**D-8000 München 2 (DE)**

(72) Erfinder : **Adi, Wael, Dr.**
**Ludwigstrasse 33a**
**D-3300 Braunschweig (DE)**

**Beschreibung**

Die Erfindung bezieht sich auf eine Schaltungsanordnung zur Erkennung und Korrektur von Fehlerbündeln gemäß dem Oberbegriff des Hauptanspruches.

Auf dem Gebiet der Datenverarbeitung sind im Zusammenhang mit der Erkennung und Korrektur eventuell auftretender Fehler verschiedene redundante Codes bekannt geworden, bei denen die zu übertragenden oder zu speichernden Datenwörter durch aus den Datenbits gewonnene Redundanzbits entsprechend ergänzt werden. Bei der Auswertung dieser redundanten Dateninformation werden dann aus den Datenbits erneut Redundanzbits gewonnen und mit den vorher abgeleiteten Redundanzbits verglichen. Die aus dem Vergleich gewonnenen, als Syndrom bezeichneten Signale werden schließlich zur Lokalisierung und gegebenenfalls zur Korrektur der jeweiligen Fehlerstelle verwendet.

Neben einer Fülle von Verfahren zur Erkennung und Korrektur von Einzel- und verteilten Mehrfachfehlern sind auch Verfahren und Schaltungsanordnungen bekannt (DE-AS 20 53 836, W.W. Peterson « Prüfbare und korrigierbare Codes » 1967, R. Oldenbourg Verlag), die unter Anwendung sogenannter zyklischer Codes, z. B. des Firecode, eine Erkennung und Korrektur von Fehlerbündeln ermöglichen. Diese Verfahren haben jedoch den Nachteil, daß sie für die Decodierung sehr viel Zeit erfordern, so daß der Lesebetrieb entsprechend behindert wird.

Der vorliegenden Erfindung liegt daher die Aufgabe zugrunde, einen Weg aufzuzeigen, wie die Erkennung und Korrektur von Fehlerbündeln unter Anwendung des Fire-Code insbesondere in bezug auf den zeitlichen Aufwand verbessert werden kann.

Diese Aufgabe wird erfindungsgemäß mit den kennzeichnenden Merkmalen des Hauptanspruches gelöst. Der Vorteil der erfindungsgemäßen Schaltungsanordnung unter Verwendung eines speziell ausgebildeten rückgekoppelten Schieberegisters liegt vor allem darin, daß mit maximal nur $r - m$-Taktschritten, d. h. Schiebeschritten des Registers, ein gegebenenfalls vorhandenes Fehlermuster ermittelt werden kann, so daß der Inhalt des Schieberegisters im Höchstfall nur über die Länge der ersten drei Teilregister durchgeschoben werden muß.

Gemäß einer vorteilhaften Weiterbildung des Erfindungsgedankens läßt sich der genaue Ort der Fehlerstelle innerhalb des Datenwortes dadurch ermitteln, daß die erfindungsgemäße Schaltungsanordnung gemäß Hauptanspruch durch die Merkmale des Anspruches 2 ergänzt wird.

Weitere vorteilhafte Ausgestaltungen des Erfindungsgedankens sind in den Unteransprüchen 3 bis 6 angegeben.

Im folgenden wird ein Ausführungsbeispiel der Erfindung anhand der Zeichnung näher erläutert. Dabei zeigen :

Figur 1 das Blockschaltbild einer Schaltungsanordnung gemäß der Erfindung,

Figur 2 das Datenformat eines erfindungsgemäß verwendeten Datenwortes mit Fehlerort-Adressierung,

Figur 3 eine vereinfachte Variante der Schaltung gemäß Fig. 1.

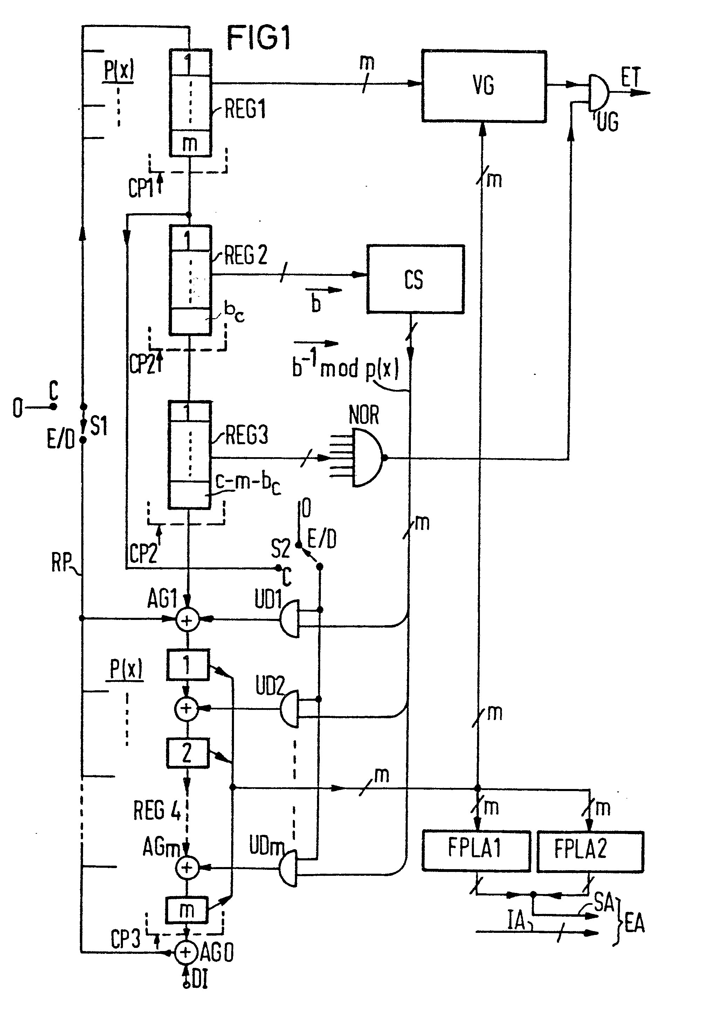

Die Fig. 1 zeigt im linken Teil ein aus vier in Reihe geschalteten Teilregistern REG1, 2, 3, 4 aufgebautes Schieberegister mit linearer Rückkopplung. Der Dateneingang DI ist mit dem Ausgang des Schieberegisters über ein modulo-2-Addierglied AGO verknüpft, dessen Ausgang wiederum mit dem zum Eingang des Schieberegisters führenden Rückkopplungspfad RP verbunden ist. Das dem Dateneingang DI zugeführte, aus Datenbits und Redundanzbits zusammengesetzte Signal ist nach den Gesetzen des Fire-Code entsprechend codiert. Nach W.W. Peterson : « Prüfbare und korrigierbare Codes », 1967, Seiten 242 ff. ist ein Fire-Code ein zyklischer Code, der in allgemeiner Form durch das Generatorpolynom $G(x) = p(x) (x^c - 1)$ definiert ist, wobei $p(x)$ ein irreduzibles Polynom vom Grade $m$ ist, dessen Wurzeln die Ordnunge $e$ haben. Ferner gilt, daß $c$ nicht durch $e$ teilbar ist. Die Länge $n$ des Code ist gleich dem kleinsten gemeinsamen Vielfachen von $e$ und $c$, denn dann ist $G(x)$ ein Teiler von $x^n - 1$. Die Anzahl der Redundanzbits beträgt $c + m = r$, die der Datenbits $n - c - m$ bzw. $n - r$. Mit diesem Fire-Code kann jedes einzelne Fehlerbündel der Länge $b_o$ oder kleiner $b_o$ korrigiert und gleichzeitig jedes Bündel, dessen Länge kleiner oder gleich $d \geqslant b_o$ ist, erkannt werden, sofern $c \geqslant b_o + d - 1$ und $m \geqslant b_o \geqslant b_c$ ist, wobei $b_o$ die Länge bzw. Bitzahl eines maximal fehlerkorrigierbaren Einzelbündels, $b_c$ die implementierte Korrigierbarkeit und $d$ die Länge bzw. Bitzahl eines erkennbaren Fehlerbündels bedeuten. Ausgehend von den Bedingungen des Fire-Code ist nun das Schieberegister gemäß Fig. 1 wie folgt zusammengesetzt. Das erste und vierte Teilregister REG1 und REG4 besteht jeweils aus $m$ Bitspeicherstellen, während das zweite Teilregister REG2 aus $b_c$ Bitspeicherstellen und das dritte Teilregister REG3 aus $c - m - b_c$ Bitspeicherstellen aufgebaut ist. Für das gesamte Schieberegister ergeben sich somit $r$ Bitspeicherstellen. Im Teilregister REG4 ist ferner vor jeder Bitspeicherstelle je ein modulo-2-Addierglied AG1 ... m eingeschaltet. Die Rückkopplung dieses vierten Teilregisters REG4 erfolgt dabei in der Weise, daß entsprechend dem Muster des jeweils verwendeten Polynoms diejenigen modulo-2-Addierglieder, die den Bitspeicherstellen für die im Polynom jeweils auftretenden Koeffizienten vorgeschaltet sind, mit ihrem jeweils zweiten Eingang mit dem Rückkopplungspfad RP verbunden sind. So ist beispielsweise bei Verwendung des Polynoms $p(x) = 1 + x^4 + x^{13} + x^{15} + x^{16}$ jeweils das modulo-2-Addierglied vor der ersten $(x^0)$, fünften $(x^4)$, vierzehnten $(x^{13})$ und sechzehnten $(x^{15})$ Bitspeicherstelle mit dem Rückkopplungspfad RP verbunden. Diese Rückkopplungsschaltung für das vierte Teilregister REG4 ist in analoger Weise auch im ersten Teilregister REG1 vorgesehen.

Zum Auffinden eines Fehlermusters wird nun der als Syndrom S bezeichnete Inhalt des gesamten Schieberegisters taktweise, und zwar mit dem gleichen Takt CP1 = CP2 = CP3 solange, d. h. maximal c Schritte weitergeschoben, bis in den beiden Teilregistern REG1 und REG4 jeweils das gleiche Bitmuster auftritt. Wenn außerdem im dritten Teilregister REG3 nur Nullen enthalten sind, dann tritt im zweiten Teilregister REG2 das gesuchte Fehlermuster auf. Wenn nach maximal c Schritten diese Bedingungen nicht erfüllt sind, bedeutet das, daß ein nichtkorrigierbarer Fehler vorliegt.

Zur Auswertung dieses Signalzustandes sind die Ausgänge der beiden Teilregister REG1 und REG4 mit den Eingängen einer Vergleicherstufe VG verbunden, deren Ausgang mit dem über ein NOR-Glied NOR geführten Ausgang des dritten Teilregisters über ein UND-Glied UG konjunktiv verknüpft ist. Das Ausgangssignal ET dieses UND-Gliedes UG zeigt schließlich an, ob im zweiten Teilregister REG2 ein Fehlermuster enthalten ist.

Um nun die genaue Fehlerstelle innerhalb des Datenwortes zu ermitteln, werden die $b_c$ Bits des im zweiten Teilregister REG2 aufscheinenden Fehlermusters $\vec{b}$ mittels einer Codierstufe CS in einen invertierten Vektor $\vec{b}^{-1}$ mod p(x) mit m Bits transformiert. Diese m Bits des invertierten Fehlermusters werden nun mit den m Bits des ersten Teilregisters REG1 multipliziert. Dies geschieht über insgesamt m UND-Glieder UD1 ... m, deren Ausgänge jeweils mit einem dritten Eingang der im vierten Teilregister REG4 vorgesehenen modulo-2-Addierglieder AG1 ... m verbunden sind. Vorher wurden sämtliche Bitspeicherstellen des vierten Teilregisters REG4 und der Schieberegistertakt CP2 des zweiten und dritten Teilregisters REG2, 3 auf Null gesetzt.

Damit die m Bits des ersten Teilregisters REG1 seriell ausgelesen werden können, muß erstens die Rückkopplung dieses Registers aufgehoben werden, was durch eine Unterbrechung des Rückkopplungspfades RP mittels eines Schalters S1 (Stellung 0) geschieht und zweitens eine Verbindung zwischen dem Ausgang des ersten Teilregisters REG1 und den Eingängen der UND-Glieder UD1 ... m hergestellt werden. Letzteres erfolgt durch Umschalten des Schalters S2 in die Stellung C. Das Multiplikationsergebnis wird schließlich an den m Bitspeicherstellen des vierten Teilregisters REG4 ausgegeben und einer Decodierstufe zugeführt. Diese Decodierstufe besteht im vorliegenden Ausführungsbeispiel aus zwei frei programmierbaren Logikschaltungen FPLA1, FPLA2, in denen verschiedene Bitmuster gemäß der Formel

$$M(x) = [x^m \sum_{i=0}^{SA} x^{ic}] \bmod p(x)$$

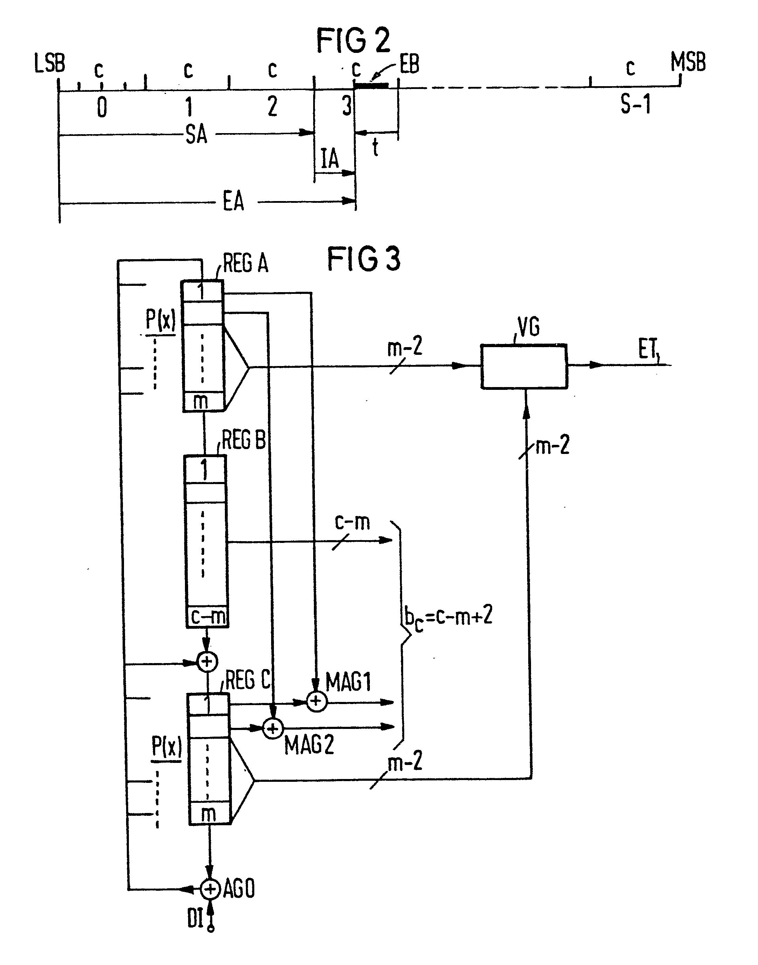

gespeichert sind, wobei jedes Muster als Sektoradresse SA auf einen jeweils zugeordneten Sektor der Länge c innerhalb des Datenwortes zeigt. Falls keines dieser Muster auftritt, dann ist der Fehler nicht korrigierbar. Aus der Zahl t der für das Auffinden des Fehlermusters notwendigen Schieberegister-Taktschritte ergibt sich außerdem die sogenannte innersektorielle Adresse IA, derart, daß die Taktschritte vom Ende des jeweils durch die Sektoradresse SA markierten Sektors zurückgezählt werden. Anhand des in Fig. 2 schematisch dargestellten Datenformats für ein in S Sektoren unterteiltes Datenwort ergibt sich, daß die Sektoradresse SA beispielsweise auf dem Sektor 3 zeigt, und daß sich die innersektorielle Adresse IA als Differenz aus den c Bits dieses Sektors minus der Zahl der Taktschritte t errechnet. Die Fehleradresse EA = SA + IA zeigt dann direkt auf den Beginn des Fehlerbündels EB innerhalb des Datenwortes.

Die Fig. 3 zeigt eine vereinfachte Variante der Schaltungsanordnung gemäß Fig. 1. Für diese Schaltungsvariante gilt die Bedingung, daß die implementierte Korrigierbarkeit, d. h. die Bitzahl $b_c$ eines korrigierbaren Fehlerbündels gleich oder größer der Anzahl der zwischen dem ersten und letzten Teilregister verbleibenden Bitspeicherzellen ist. Für $b_c \geq c - m \geq r - 2m$ ergibt sich für das rückgekoppelte Schieberegister folgender vereinfachter Aufbau. Das erste bzw. letzte Teilregister REGA, REGC entspricht hinsichtlich der Zahl der Bitspeicherstellen — jeweils m Stellen — und hinsichtlich der Rückkopplungspfade genau dem ersten bzw. vierten Teilregister REG1 und REG4 der Schaltung gemäß Fig. 1. Dazwischen liegt nur noch ein Teilregister, nämlich das mittlere Teilregister REGB, das ingesamt c − m Bitspeicherstellen aufweist. Wenn nun dieses Schieberegister wieder solange, d. h. maximal c Schritte weitergeschoben wird, bis in den beiden Teilregistern REGA und REGC jeweils das gleiche Bitmuster auftritt, dann ist, sofern $b_c = c - m$, im mittleren Teilregister REGB ein Fehlermuster mit der vollen Bitzahl dieses Teilregisters vorhanden. Das Auftreten eines Fehlermusters wird auch hier mittels einer Vergleicherstufe VG durch ein Fehlersignal ET angezeigt. Die Schaltungsanordnung gemäß Fig. 3 zeigt darüber hinaus den Sonderfall, wenn $b_c \geq c - m$ ist, d. h. wenn die Bitzahl $b_c$ des Fehlermusters um z Bitstellen, beispielsweise um zwei Bitstellen größer ist als die Anzahl c − m der Bitspeicherstellen im mittleren Teilregister REGB. In diesem Fall werden dann die jeweils ersten z bzw. 2 Bitspeicherstellen des ersten und letzten Teilregisters REGA, REGC über je ein modulo-2-Addierglied MAG1 ... z bzw. MAG1, MAG2 miteinander verknüpft, deren Ausgangssignale zusammen mit dem Inhalt des mittleren Teilregisters REGB das vollständige Fehlermuster ergeben. Entsprechend erfolgt der Signalvergleich in der Vergleicherstufe VG nicht mehr mit allen m Bits des ersten und letzten Teilregisters REGA und REGC, sondern nur noch mit m − z bzw. m − 2 Bits.

# 0 046 963

**Ansprüche**

1. Schaltungsanordnung zur Erkennung und Korrektur von Fehlerbündeln in durch Redundanzbits ergänzten Datenwörtern, unter Anwendung eines durch das Generator-Polynom $G(x) = (1 + x^c) \, p(x)$ definierten Fire-Code, bei dem die Bedingungen $c = r - m$ mit $r$ = Zahl der Redundanzbits und $m$ = Grad des irreduziblen Polynoms $p(x)$ und $m \geqslant b_o \geqslant b_c$ mit $b_o$ = Länge bzw. Bitzahl eines maximal fehlerkorrigierbaren Einzelbündels und $b_c$ = implementierte Korrigierbarkeit eines Fehlerbündels gelten, sowie unter Verwendung eines rückgekoppelten Schieberegisters, dadurch gekennzeichnet, daß das rückgekoppelte Schieberegister mit einer Gesamtlänge von $r$ Bitspeicherstellen in vier Teilregister (REG1, 2, 3, 4) unterteilt ist, daß das erste und vierte Teilregister (REG1, REG4) jeweils $m$ Bitspeicherstellen und entsprechend dem verwendeten Polynommuster vor jeder der den einzelnen Polynomkoeffizienten zugeordneten Bitspeicherstellen je ein modulo-2-Addierglied mit zugehörigem Rückkopplungspfad aufweisen, daß das zweite Teilregister (REG2) aus $b_c$ Bitspeicherstellen und das dritte Teilregister (REG3) aus $c - m - b_c$ Bitspeicherstellen besteht, daß die Ausgänge des ersten und vierten Teilregisters (REG1, REG4) an die Eingänge einer Vergleicherstufe (VG) geführt sind, deren Ausgang mit dem über ein NOR-Glied (NOR) geführten Ausgang des dritten Teilregisters (REG3) über ein UND-Glied (UG) konjunktiv verknüpft ist und daß am Ausgang dieses UND-Gliedes (UG) bei nicht auf Null stehendem Registerinhalt aller Teilregister (REG1, 2, 3, 4) jedoch gleichen Eingangssignalen an der Vergleicherstufe (VG), sowie bei Nullstellung sämtlicher Bitspeicherstellen des dritten Teilregisters (REG3) ein Fehlersignal (ET) auftritt, welches anzeigt, daß im zweiten Teilregister (REG2) ein Fehlermuster enthalten ist.

2. Schaltungsanordnung nach Anspruch 1, dadurch gekennzeichnet, daß der Ausgang des zweiten Teilregisters (REG2) mit einer Codierstufe (CS) verbunden ist, welche die $b_c$ Bits des Fehlermusters $\vec{b}$ in einen invertierten Vektor $\vec{b}^{-1}$ mod $p(x)$ mit $m$ Bits transformiert und daß diese $m$ Bits und der Inhalt des ersten Teilregisters (REG1) einem Multiplizierwerk zugeführt sind, dessen Ausgangssignal das Ergebnis einer mod $p(x)$-Multiplikation der beiden Eingangssignale liefert.

3. Schaltungsanordnung nach Anspruch 2, dadurch gekennzeichnet, daß die $m$ Bits des invertierten Fehlermuster-Vektors $\vec{b}^{-1}$ mod $p(x)$ über je ein UND-Glied (UD1 ... m) mit den seriell ausgelesenen $m$ Bits des ersten Teilregisters (REG1) konjunktiv verknüpft sind und daß die Ausgänge dieser UND-Glieder (UD1 ... m) mit je einem weiteren Eingang der bitmäßig zugeordneten modulo-2-Addierglieder (AG1 ... m) des vorher auf Null geschalteten vierten Teilregisters (REG4) verbunden sind.

4. Schaltungsanordnung nach Anspruch 2 oder 3, dadurch gekennzeichnet, daß das an den $m$ Bitspeicherstellen des vierten Teilregisters (REG4) auftretende Multiplikationsergebnis einer Decodierstufe (FPLA1, FPLA2) zugeführt ist, deren Ausgangssignal als Sektoradresse (SA) auf einen bestimmten Sektor der Länge $c$ innerhalb des Datenwortes zeigt, und daß sich die innersektorielle Adresse (IA) der innerhalb des Sektors auftretenden Fehlerstelle durch die Zahl der für das Auffinden des Fehlermusters notwendigen Schieberegister-Taktschritte bestimmt wird, derart, daß die Taktschritte vom Ende des jeweiligen Sektors zurückgezählt werden.

5. Schaltungsanordnung zur Erkennung und Korrektur von Fehlerbündeln in durch Redundanzbits ergänzten Datenwörtern unter Anwendung eines durch das Generatorpolynom $G(x) = (1 + x^c) \, p(x)$ definierten Fire-Code, bei dem die Bedingungen $c = r - m$ mit $r$ = Zahl der Redundanzbits und $m$ = Grad des irreduziblen Polynoms $p(x)$ und $b_c = c - m = r - 2m$ mit $b_c$ = implementierte Korrigierbarkeit eines Fehlerbündels gelten, sowie unter Verwendung eines rückgekoppelten Schieberegisters, dadurch gekennzeichnet, daß das rückgekoppelte Schieberegister mit einer Gesamtlänge von $r$ Bitspeicherstellen in drei Teilregister (REGA, REGB, REGC) unterteilt ist, daß das erste und letzte Teilregister (REGA, REGC) jeweils $m$ Bitspeicherstellen und entsprechend dem verwendeten Polynommuster vor jeder der den einzelnen Polynomkoeffizienten zugeordneten Bitspeicherstellen je ein modulo-2-Addierglied mit zugehörigem Rückkopplungspfad aufweisen, daß das mittlere Teilregister (REGB) aus $c - m$ Bitspeicherstellen besteht, daß die Ausgänge des ersten und letzten Teilregisters (REGA, C) an die Eingänge einer Vergleicherstufe (VG) geführt sind und daß am Ausgang dieser Vergleicherstufe (VG) bei nicht auf Null stehendem Registerinhalt aller Teilregister (REGA, B, C), jedoch gleichen Eingangssignalen an der Vergleicherstufe (VG), ein Fehlersignal (ET) auftritt, welches anzeigt, daß im mittleren Teilregister (REGB) ein Fehlermuster enthalten ist.

6. Schaltungsanordnung nach Anspruch 5, dadurch gekennzeichnet, daß bei einem korrigierbaren Fehlerbündel, dessen Bitzahl $b_c$ um $z$ Bitstellen größer ist als die Zahl $c - m$ der Bitspeicherstellen im mittleren Teilregister (REGB), die ersten $z$ Bitspeicherstellen des letzten Teilregisters (REGC) mit den ersten $z$ Bitspeicherstellen des ersten Teilregisters (REGA) über ein modulo-2-Addierglied (MAG1 ... z) verknüpft sind, daß die Ausgänge der im ersten und letzten Teilregister (REGA, REGC) verbleibenden $m - z$ Bitspeicherstellen an die Eingänge der Vergleicherstufe (VG) geführt sind und daß das Fehlermuster aus dem Inhalt des mittleren Teilregisters (REGB) und den sich daran anschließenden Ausgangssignalen der den $z$ Bitspeicherstellen des ersten und letzten Teilregisters zugeordneten modulo-2-Addiergliedern (MAG1 ... z) gebildet ist.


**Claims**

1. A circuit arrangement for recognising and correcting error bursts in data words which are

<div align="center">4</div>

supplemented by redundancy bits, using a Fire-Code which is defined by the generator polynomial : $G(x) = (1 + x^c)\ p(x)$, where the conditions that apply are given by $c = r - m$ ; with $r$ = the number of redundancy bits ; $m$ = the order of the irreducible polynomial) $p(x)$ and $m \geqslant b_o \geqslant b_c$ ; where $b_o$ = the length or bit-count of a maximum error-correctable individual burst and $b_c$ = the implemented correctability of an error burst, and a shift register with feedback being used, characterised in that the shift register with feedback possesses an overall length of r bit storage positions, and is subdivided into four subregisters (REG1, 2, 3, 4), that the first and fourth sub-registers (REG1, REG4) each possess m bit storage positions and a respective modulo-2-adder with assigned feedback path is provided prior to bit storage positions assigned to the individual polynomial coefficients, in accordance with the polynomial pattern wich is used, that the second sub-register (REG2) consists of $b_c$ bit storage positions and the third sub-register (REG3) consists of $c - m - b_c$ bit storage positions, that the outputs of the first and fourth subregisters (REG1, REG4) lead to the inputs of a comparator stage (VG) whose output is conjunctively logic-linked *via* an AND-gate (UG) to the output of a NOR-gate (NOR) fed by the third subregister (REG3), and that when the register contents of all the sub-registers (REG1, 2, 3, 4) are not at zero but the input signals to the comparator stage (VG) are identical and when all the bit storage positions of the third sub-register (REG3) are at zero, at the output of this AND-gate (UG) there occurs an error signal (ET) which indicates that the second sub-register (REG2) contains an error pattern.

2. A circuit arrangement as claimed in Claim 1, characterised in that the output of the second sub-register (REG2) is connected to a coder stage (CS) which transforms the $b_c$ bits of the error pattern $\vec{b}$ into an inverted vector $\vec{b}^{-1}$ mod $p(x)$ with m bits, and that these m bits and the content of the first sub-register (REG1) are fed to a multiplier whose output signal supplies the result of a mod $p(x)$-multiplication of the two input signals.

3. A circuit arrangement as claimed in Claim 2, characterised in that the m bits of the inverted error pattern-vector $\vec{b}^{-1}$ mod $p(x)$ are each conjunctively logic-linked *via* a AND-gate (UD1 ... m) to the m bits which have been read out in serial fashion from the first sub-register (REG1), and that the outputs of these AND-gates (UD1 ... m) are each connected to a further input of the bit-wise allocated modulo-2 adders (AG1 ... m), of the fourth sub-register (REG4) which has been previously set at zero.

4. A circuit arrangement as claimed in Claim 2 or 3, characterised in that the multiplication result which occurs in the m bit storage positions of the fourth sub-register (REG4) is fed to a decoder stage (FPLA1, FPLA2) whose output signal points as a sector address (SA) to a specific sector of the length c within the data word, and that the inner-sector address (1A) of the error location which occurs within the sector is specified by the number of shift register-clock pulse elements which are necessary to find the error pattern in such manner that the clock pulse elements are counted back from the end of the sector in question.

5. A circuit arrangement for recognising and correcting error bursts in data words which are supplemented by redundancy bits, using a Fire-Code which is defined by the generator polynomial : $G(x) = (1 + x^c)\ p(x)$, wherein the conditions which apply are given by : $c = r - m$ ; where r = the number of redundancy bits, m = the order of the irreducible polynomial $p(x)$, and $b_c = c - m = r - 2m$ ; where $b_c$ = the implemented correctability of an error burst, and a shift register with feedback being used, characterised in that the shift register with feedback possesses an overall length of r bit storage positions, and is subdivided into three sub-registers (REGA, REGB, REGC), that the first and last sub-registers (REGA, REGC) each possess m bit storage positions and is provided with a separate modulo-2 adder with associated feedback path prior to bit storage positions assigned to the individual polynomial coefficients in accordance with the polynomial pattern which is used, that the central sub-register (REGB) consists of $c - m$ bit storage positions, that the outputs of the first and last sub-registers (REGA, C) lead to the inputs of a comparator stage (VG), and that when the register contents of all the sub-registers (REGA, B, C) are not at zero but the input signals to the comparator stage (VG) are identical, at the output of this comparator stage (VG) there occurs an error signal (ET) which indicates that the central sub-register (REGB) contains an error pattern.

6. A circuit arrangement as claimed in Claim 5, characterised in that in the case of a correctable error burst whose bit number $b_c$ exceeds the number $c - m$ of the bit storage positions in the central sub-register (REGB) by z bit positions, the first z bit storage positions of the last sub-register (REGC) are logic-linked to the first z bit storage positions of the first sub-register (REGA) *via* a modulo-2 adder (MAG1 ... z), that the outputs of the $m - z$ bit storage positions which remain in the first and last sub-registers (REGA, REGC) lead to the inputs of the comparator stage (VG) and that the error pattern is composed of the content of the central sub-register (REGB), and the adjoining output signals of the modulo-2 adders (MAG1 ... z) which are assigned to the z bit storage positions of the first and last sub-registers.

**Revendications**

1. Montage pour identifier et corriger des paquets d'erreurs dans des mots de données complétés par des bits de redondance, moyennant l'utilisation d'un code Fire défini par le polynôme générateur $G(x) = (1 + x^c)\ p(x)$, dans lequel on a les conditions $c = r - m$ avec r = nombre des bits de redondance et m = degré du polynôme irréductible $p(x)$ et $m \geqslant b_o \geqslant b_c$ avec $b_o$ = longueur ou nombre des bits d'un paquet individuel à correction maximale des erreurs et $b_c$ = mise en œuvre de correction d'un paquet d'erreurs, ainsi que moyennant l'utilisation d'un registre à décalage couplé par réaction, caractérisé par le fait que le registre à décalage couplé par réaction, possédant une longueur totale de r positions de mémorisation de bits, est subdivisé en quatre registres partiels (REG1, 2, 3, 4), que le premier et le quatrième registres partiels (REG1, REG4) comportent chacun m positions de mémorisation de bits et, conformément au modèle de polynôme utilisé, un circuit additionneur modulo 2 muni d'une voie de réaction associée, en amont de chacune des positions de mémorisation de bits associées aux différents coefficients du polynôme, que le second registre partiel (REG2) est constitué par $b_c$ positions de mémorisation de bits et que le troisième registre à décalage (REG3) est constitué par $c - m - b_c$ positions de mémorisation de bits, que les sorties du premier et du quatrième registres partiels (REG1, REG4) sont raccordées aux entrées d'un étage comparateur (VG), dont la sortie est reliée selon une fonction ET par l'intermédiaire d'un circuit ET (UG) à la sortie, raccordée par l'intermédiaire d'un circuit NON-OU (NOR), du troisième registre partiel (REG3) et que dans le cas où les contenus de tous les registres partiels (REG1, 2, 3, 4) ne sont pas nuls mais où des signaux identiques d'entrée sont envoyés à l'étage comparateur (VG), ainsi que dans le cas où toutes les positions de mémorisation de bits du troisième registre partiel (REG3) sont nulles, il apparaît à la sortie du circuit ET (UG) un signal d'erreur (ET) qui indique qu'un profil d'erreur est contenu dans le second registre partiel (REG2).

2. Montage suivant la revendication 1, caractérisé par le fait que la sortie du second registre partiel (REG2) est reliée à un étage de codage (CS), qui transforme les $b_c$ bits du profil d'erreur $\overrightarrow{b}$ en un vecteur inversé $\overrightarrow{b}^{-1}$ mod p(x) comportant m bits, et que ces m bits et le contenu du premier registre partiel (REG1) sont envoyés à un multiplicateur, dont le signal de sortie délivre le résultat d'une multiplication mod p(x) des deux signaux d'entrée.

3. Circuit suivant la revendication 2, caractérisé par le fait que les m bits du vecteur inversé du profil binaire $\overrightarrow{b}^{-1}$ mod p(x) sont réunis selon la fonction ET par l'intermédiaire d'un circuit ET (UD1 ... m) aux m bits lus en série du premier registre partiel (REG1), et que les sorties de ces circuits ET (UD1 ... m) sont reliées chacune à une autre entrée des circuits additionneurs modulo 2 (AG1 ... m), associés au niveau des bits, du quatrième registre partiel (REG4) préalablement réglé à zéro.

4. Montage suivant la revendication 2 ou 3, caractérisé par le fait que le résultat de la multiplication, qui apparaît dans les m positions de mémorisation de bits du quatrième registre partiel (REG4), est envoyé à un étage décodeur (FPLA1, FPLA2) dont le signal de sortie indique, en tant qu'adresse de secteur (SA), un secteur déterminé de longueur c à l'intérieur du mot de données, et que l'adresse, interne au secteur, (IA) de la zone d'erreur apparaissant à l'intérieur du secteur est déterminée par le nombre des pas de cadence du registre à décalage, nécessaires pour trouver le profil d'erreur, grâce au fait que les pas de cadence sont décomptés selon un comptage régressif à partir de la fin du secteur respectif.

5. Montage pour identifier et corriger des paquets d'erreurs dans des mots de données, complétés par des bits de redondance, moyennant l'utilisation d'un code Fire défini par le polynôme générateur $G(x) = (1 + x^c)$ p(x), pour lequel on a les conditions $c = r - m$ avec r = nombre des bits de redondance et m = degré du polynôme irréductible p(x) et $b_c = c - m = r - 2m$ avec $b_c$ = capacité de correction mise en œuvre d'un paquet d'erreurs, ainsi que moyennant l'utilisation d'un registre à décalage couplé par réaction, caractérisé par le fait que le registre à décalage couplé par réaction, d'une longueur totale de r positions de mémorisation de bits est subdivisé en trois registres partiels (REGA, REGB, REGC), que le premier et le dernier registres partiels (REGA, REGC) comportent chacun m positions de mémorisation de bits et, conformément au modèle de polynôme utilisé, un circuit additionneur modulo 2 muni d'une voie de réaction associée, en amont de chacune des positions de mémorisation de bits associées aux différents coefficients du polynôme, que le registre partiel médian (REGB) est constitué par $c - m$ positions de mémorisation de bits, que les sorties du premier et du dernier registres partiels (REGA, C) sont raccordés aux entrées d'un étage comparateur (VG) et que dans le cas où les contenus de tous les registres partiels (REGA, B, C) ne sont pas réglés à zéro, mais que des signaux d'entrée identiques arrivent à l'étage comparateur (VG), il apparaît à la sortie de cet étage comparateur (VG) un signal d'erreur (ET) qui indique qu'un profil d'erreur est contenu dans le registre partiel médian (REGB).

6. Montage suivant la revendication 5, caractérisé par le fait que dans le cas d'un paquet d'erreurs pouvant être corrigé, dont le nombre de bits $b_c$ est supérieur de z positions binaires au nombre $c - m$ des positions de mémorisation de bits dans le registre partiel médian (REGB), les z premières positions de mémorisation de bits du dernier registre partiel (REGC) sont combinées aux z premières positions de mémorisation de bits du premier registre partiel (REGA) par l'intermédiaire d'un circuit additionneur modulo 2 (MAG1 ... z), que les sorties des $m - z$ positions de mémorisation de bits subsistant dans le premier et le dernier registres partiels (REGA, REGC) sont envoyées aux entrées de l'étage comparateur (VG), et que le profil d'erreur est formé à partir du contenu du registre partiel médian (REGB) et à partir des signaux de sortie successifs des circuits additionneurs modulo 2 (MAG1 ... z) associés aux z positions de mémorisation de bits du premier et du dernier registres partiels.

FIG1

## FIG 2

## FIG 3